(19) Europäisches Patentamt / European Patent Office / Office européen des brevets

(11) **EP 3 872 507 B1**

(12) **EUROPEAN PATENT SPECIFICATION**

(45) Date of publication and mention
of the grant of the patent:
**11.05.2022 Bulletin 2022/19**

(21) Application number: **20758685.0**

(22) Date of filing: **07.02.2020**

(51) International Patent Classification (IPC):
*G01R 31/3835* (2019.01)   *G01R 31/396* (2019.01)
*G01R 31/367* (2019.01)   *H01M 10/42* (2006.01)
*H01M 10/48* (2006.01)

(52) Cooperative Patent Classification (CPC):
**G01R 31/367; H01M 10/425; H01M 10/48;
H01M 10/486;** G01R 31/374; G01R 31/3842;
H01M 2010/4271; Y02E 60/10

(86) International application number:
**PCT/KR2020/001773**

(87) International publication number:
**WO 2020/171442 (27.08.2020 Gazette 2020/35)**

(54) **BATTERY MANAGEMENT SYSTEM, BATTERY MANAGEMENT METHOD, BATTERY PACK, AND ELECTRIC VEHICLE**

BATTERIEVERWALTUNGSVORRICHTUNG, BATTERIEVERWALTUNGSVERFAHREN, BATTERIEPACK UND ELEKTROFAHRZEUG

SYSTÈME DE GESTION DE BATTERIE, PROCÉDÉ DE GESTION DE BATTERIE, BLOC-BATTERIE ET VÉHICULE ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **22.02.2019 KR 20190021448
04.02.2020 KR 20200013286**

(43) Date of publication of application:
**01.09.2021 Bulletin 2021/35**

(73) Proprietor: **LG Energy Solution, Ltd.
Seoul 07335 (KR)**

(72) Inventor: **KIM, Young-Jin
Daejeon 34122 (KR)**

(74) Representative: **Plasseraud IP
66, rue de la Chaussée d'Antin
75440 Paris Cedex 09 (FR)**

(56) References cited:
JP-A- 2004 514 249   JP-A- 2007 033 112
JP-A- 2012 047 580   KR-A- 20060 129 962
US-A1- 2007 005 276   US-A1- 2014 214 348
US-B2- 7 352 156

**Description**

TECHNICAL FIELD

The present disclosure relates to battery state of charge (SOC) estimation using an extended Kalman filter.

BACKGROUND ART

Recently, there has been dramatically growing demand for portable electronic products such as laptop computers, video cameras and mobile phones, and with the extensive development of electric vehicles, accumulators for energy storage, robots and satellites, many studies are being made on batteries that can be recharged repeatedly.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

One of important parameters required to control the charge/discharge of a battery is State of Charge (SOC). The SOC is a parameter indicating a relative ratio of the remaining capacity to the maximum capacity indicating electrical energy stored in the battery when the battery is fully charged, and may be expressed as 0 to 1 or 0% to 100%. For example, when the maximum capacity and the remaining capacity of the battery are 1000Ah (ampere-hour) and 750Ah respectively, the SOC of the battery is 0.75 (or 75%).

Ampere counting, an equivalent circuit model and the extended Kalman filter are typically used to estimate the SOC of the battery. The ampere counting is the technique that estimates the SOC of the battery based on a cumulative current value corresponding to the current flowing through the battery accumulated over time. The equivalent circuit model is designed to model the connection relationship between electrical components to simulate the electrochemical properties of the battery.

However, due to a measurement error of a current sensor and/or external noise, the ampere counting may have a discrepancy between the SOC estimated by ampere counting and the actual SOC. Additionally, it is very difficult to design the equivalent circuit model for sufficiently simulating the nonlinear characteristic of the battery associated with a rapid change in open circuit voltage (OCV) within a predetermined range in which the SOC is close to the full discharge state.

The extended Kalman filter is the mathematically combined technique of the ampere counting and the equivalent circuit model to make up for the drawback of each of the ampere counting and the equivalent circuit model.

However, even though the extended Kalman filter is used, when the above-described nonlinear characteristic is very strong, an error may occur to the estimate of SOC of the battery. US 2014/214348 A1 and US 2007/005276 A1 disclose background art.

DISCLOSURE

Technical Problem

The present disclosure is designed to solve the above-described problem, and therefore the present disclosure is directed to providing a battery management system, a battery management method, a battery pack and an electric vehicle in which in estimating (updating) the SOC of the battery in each cycle using the extended Kalman filter, open circuit voltage (OCV) information is determined based on the results of comparison between the temporary estimate indicating the SOC in the current cycle and the reference range strongly showing the nonlinear characteristic, then a definitive estimate indicating the SOC in the current cycle is determined based on the OCV information.

The present disclosure is further directed to providing a battery management system, a battery management method and a battery pack in which the SOC of the battery is estimated with higher reliability by adjusting the maximum value of the reference range based on the maximum capacity associated with the degradation level of the battery.

These and other objects and advantages of the present disclosure may be understood by the following description and will be apparent from the embodiments of the present disclosure. In addition, it will be readily understood that the objects and advantages of the present disclosure may be realized by the means set forth in the appended claims and a combination thereof.

Technical Solution

A battery management system according to an aspect of the present disclosure includes a sensing unit configured to generate battery information indicating a current, a voltage and a temperature of a battery, and a control unit configured to estimate a state of charge (SOC) of the battery using an extended Kalman filter based on the battery information. The control unit is configured to determine a temporary estimate for a SOC in a current cycle using a time update process of the extended Kalman filter based on a previous estimate and the battery information. The previous estimate indicates a SOC in a previous cycle. The control unit is configured to determine open circuit voltage (OCV) information based on the temporary estimate. The control unit is configured to determine a definitive estimate indicating the SOC in the current cycle using a measurement update process of the extended Kalman filter based on the temporary estimate, the OCV information and the battery information.

The OCV information may include a first OCV factor value. The control unit may be configured to determine the first OCV factor value to be equal to a predetermined first slope control value when the temporary estimate is outside of a reference range.

The control unit may be configured to determine the first OCV factor value to be equal to a second slope control value when the temporary estimate is within the reference range. The second slope control value is smaller than the first slope control value.

The control unit may be configured to determine a maximum value of the reference range based on a maximum capacity of the battery.

The control unit may be configured to increase the maximum value of the reference range as a difference between a design capacity of the battery and the maximum capacity increases.

The OCV information may include a second OCV factor value. The control unit may be configured to determine the second OCV factor value to be equal to a first OCV corresponding to the temporary estimate from a data table defining a correspondence relationship between the SOC and the OCV of the battery when the temporary estimate is outside of the reference range.

The control unit may be configured to determine the second OCV factor value to be equal to a second OCV corresponding to a maximum value of the reference range when the temporary estimate is within the reference range. The maximum value of the reference range is equal to or larger than a predetermined reference value.

A battery pack according to another aspect of the present disclosure includes the battery management system.

An electric vehicle according to still another aspect of the present disclosure includes the battery pack.

A battery management method according to yet another aspect of the present disclosure may be executable by the battery management system. The battery management method includes collecting battery information indicating a current, a voltage and a temperature of the battery, determining a temporary estimate for a SOC in a current cycle using a time update process of an extended Kalman filter based on a previous estimate indicating a SOC in a previous cycle and the battery information, determining OCV information based on the temporary estimate, and determining a definitive estimate indicating the SOC in the current cycle using a measurement update process of the extended Kalman filter based on the temporary estimate, the OCV information and the battery information.

Determining the OCV information may determining a first OCV factor value to be equal to a predetermined first slope control value when the temporary estimate is outside of a reference range, and determining the first OCV factor value to be equal to a second slope control value when the temporary estimate is within the reference range, the second slope control value being smaller than the first slope control value. The OCV information may include the first OCV factor value.

Determining the OCV information may include determining a second OCV factor value to be equal to an OCV corresponding to the temporary estimate from a data table defining a correspondence relationship between the SOC and the OCV of the battery when the temporary estimate is outside of a reference range, and determining the second OCV factor value to be equal to a threshold voltage associated with the reference range when the temporary estimate is within the reference range. The OCV information may include the second OCV factor value.

Advantageous Effects

According to at least one of the embodiments of the present disclosure, in estimating (updating) the SOC of the battery in each cycle using the extended Kalman filter, open circuit voltage (OCV) information may be determined based on the results of comparison between the temporary estimate indicating the SOC in the current cycle and the reference range strongly showing the nonlinear characteristic, and a definitive estimate indicating the SOC in the current cycle may be determined based on the OCV information. Accordingly, it is possible to reduce the adverse influence of a rapid change in OCV due to the nonlinear characteristic of the battery on the accuracy of battery SOC estimation.

Additionally, according to at least one of the embodiments of the present disclosure, it is possible to estimate the SOC of the battery with higher reliability by adjusting the maximum value of the reference range based on the maximum capacity associated with the degradation level of the battery.

The effects of the present disclosure are not limited to the effects mentioned above, and these and other effects will be clearly understood by those skilled in the art from the appended claims.

BRIEF DESCRIPTION OF DRAWINGS

FIG. 1 is an exemplary diagram of a configuration of an electric vehicle according to the present disclosure.

FIG. 2 is an exemplary diagram of a circuit configuration of an equivalent circuit model of a battery.

FIG. 3 is an exemplary diagram of an open circuit voltage (OCV)-state of charge (SOC) curve of a battery.

FIG. 4 is an exemplary flowchart showing a battery management method that may be performed by a battery management system of FIG. 1.

FIG. 5 is an exemplary flowchart showing a method of determining a first OCV factor value as OCV information according to an embodiment of the present disclosure.

FIG. 6 is an exemplary flowchart showing a method of determining a second OCV factor value as OCV information according to another embodiment of the present disclosure.

DETAILED DESCRIPTION

Hereinafter, the preferred embodiments of the present disclosure will be described in detail with reference to the accompanying drawings. Prior to the description, it should be understood that the terms or words used in the specification and the appended claims should not be construed as being limited to general and dictionary meanings, but rather interpreted based on the meanings and concepts corresponding to the technical aspects of the present disclosure on the basis of the principle that the inventor is allowed to define the terms appropriately for the best explanation.

Therefore, the embodiments described herein and illustrations shown in the drawings are just a most preferred embodiment of the present disclosure, but not intended to fully describe the technical aspects of the present disclosure, so it should be understood that a variety of other equivalents and modifications could have been made thereto at the time that the application was filed.

The terms including the ordinal number such as "first", "second" and the like, are used to distinguish one element from another among various elements, but not intended to limit the elements by the terms.

Unless the context clearly indicates otherwise, it will be understood that the term "comprises" when used in this specification, specifies the presence of stated elements, but does not preclude the presence or addition of one or more other elements. Additionally, the term "control unit" as used herein refers to a processing unit of at least one function or operation, and this may be implemented by either hardware or software or a combination of hardware and software.

In addition, throughout the specification, it will be further understood that when an element is referred to as being "connected to" another element, it can be directly connected to the other element or intervening elements may be present.

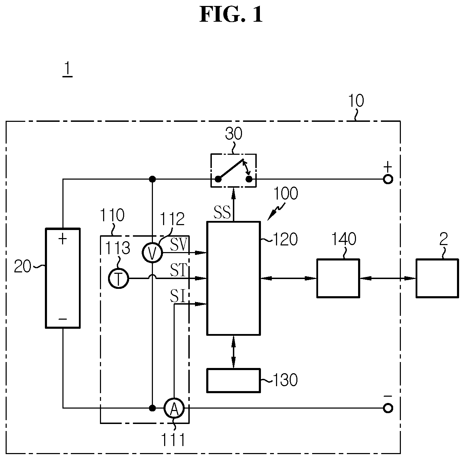

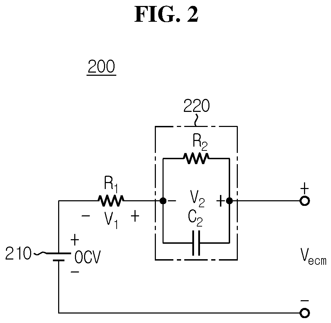

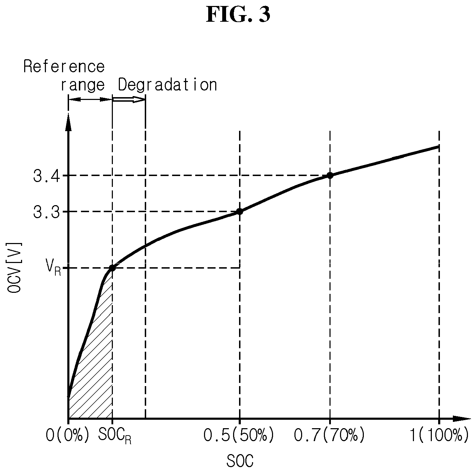

FIG. 1 is an exemplary diagram of a configuration of an electric vehicle according to the present disclosure, FIG. 2 is an exemplary diagram of a circuit configuration of an equivalent circuit model of a battery, and FIG. 3 is an exemplary diagram of an open circuit voltage (OCV)-state of charge (SOC) curve of the battery.

Referring to FIG. 1, a battery pack 10 is configured to supply electrical energy required for an electricity powered device such as an electric vehicle 1, and includes a battery 20, a switch 30 and a battery management system 100.

The battery 20 includes at least one battery cell. Each battery cell may be, for example, a lithium ion cell. Of course, the type of the battery cell is not limited to the lithium ion cell, and may include, without limitation, any type that can be recharged repeatedly. Each battery cell included in the battery 20 is electrically connected to other battery cell in series or in parallel.

The switch 30 is installed on a current path for charging and discharging the battery 20. A control terminal of the switch 30 is provided to be electrically connected to a control unit 120. The switch 30 is controlled to be turned on and off according to the duty cycle of a switching signal SS outputted by the control unit 120, in response to the switching signal SS being applied to the control terminal. When the switching signal SS is high-level, the switch 30 may be turned on, and when the switching signal SS is low-level, the switch 30 may be turned off. The current flowing through the current path is controlled by turning on and off the switch 30.

The battery management system 100 is provided to be electrically connected to the battery 20 to periodically determine the SOC of the battery 20. The battery management system 100 includes a sensing unit 110, the control unit 120, a memory unit 130 and a communication unit 140.

The sensing unit 110 is configured to periodically generate battery information indicating the voltage, current and temperature of the battery 20 during charging/discharging of the battery 20. The sensing unit 110 includes a current sensor 111, a voltage sensor 112 and a temperature sensor 113.

The current sensor 111 is provided to be electrically connected to the charge/discharge path of the battery 20. The current sensor 111 is configured to output a signal SI indicating the magnitude and direction of the current flowing through the battery 20 to the control unit 120. For example, a shunt resistor and/or a hall effect device may be used as the current sensor 111.

The voltage sensor 112 is provided to be electrically connected to positive and negative terminals of the battery 20. The voltage sensor 112 is configured to detect the voltage across the positive and negative terminals of the battery 20, and output a signal SV indicating the detected voltage to the control unit 120.

The temperature sensor 113 is configured to detect the temperature of an area within a predetermined distance from the battery 20, and output a signal ST indicating the detected temperature to the control unit 120. For example, a thermistor having the negative temperature coefficient may be used as the temperature sensor 113.

The control unit 120 is operably coupled to the sensing unit 110, the memory unit 130, the communication unit 140 and the switch 30. The control unit 120 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors and electrical units for performing other functions.

The control unit 120 is configured to periodically receive the signal SI, the signal SV and the signal ST outputted by the sensing unit 110 as the battery information. The control unit 120 may determine a current value, a voltage value and a temperature value from the signal SI, the signal SV and the signal ST respectively using an analog-to-digital converter (ADC) included in the control unit 120, and store them in the memory unit 130.

The memory unit 130 is operably coupled to the control unit 120. The memory unit 130 may store programs and data necessary to perform the steps described below. The memory unit 130 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) and programmable read-only memory (PROM).

The communication unit 140 may be coupled to an external device 2 to enable communication. For example, the external device 2 may be an Electronic Control Unit (ECU) of the vehicle 1. The communication unit 140 may receive a command message from the external device 2, and provide the received command message to the control unit 120. The command message may be a message requesting the activation of a specific function (e.g., SOC estimation, control of ON/OFF of the switch 30) of the battery management system 100. The communication unit 140 may send a notification message from the control unit 120 to the external device 2. The notification message may be a message for notifying the result (e.g., an estimate of SOC) of the function performed by the control unit 120 to the external device 2. For example, the communication unit 140 may communicate with the external device 2 via a wired network such as a local area network (LAN), a controller area network (CAN) and a daisy chain and/or a short range wireless network, for example, Bluetooth, Zigbee and WiFi.

The control unit 120 is configured to determine the maximum capacity or the state of health (SOH) of the battery 20. The maximum capacity indicates the maximum amount of charges that can be stored in the battery 20, and may be referred to as 'full charge capacity'. For example, the maximum capacity is equal to the cumulative value of currents flowing during discharging of the battery 20 at SOC of 1 (=100%) until the SOC is 0 (=0%).

The control unit 120 may calculate the internal resistance of the battery 20, and determine the SOH or the maximum capacity of the battery 20 based on a difference between the reference resistance and the internal resistance or a ratio of the internal resistance to the reference resistance. Alternatively, the control unit 120 may determine the SOH or the maximum capacity of the battery 20, based on the SOC at each of different time points at which the battery 20 is charged and discharged and the cumulative current value for a period of time between the two time points, using the following Equation 1. Assume that the earlier time point of the two time points is $t_1$, and the later time point is t2.

<Equation 1>

$$SOH_{new} = \frac{\frac{\int_{t_1}^{t_2} i_t \, dt}{SOC_2 - SOC_1}}{Q_{ref}} = \frac{\frac{\Delta C}{\Delta SOC}}{Q_{ref}} = \frac{Q_{est}}{Q_{ref}}$$

In Equation 1, $Q_{ref}$ denotes reference capacity, $SOC_1$ denotes SOC estimated at the time point $t_1$, $SOC_2$ denotes SOC estimated at the time point $t_2$, $\Delta SOC$ denotes a difference between $SOC_1$ and $SOC_2$, it denotes a current value indicating the current detected at a time point t between the time point $t_1$ and the time point t2, $\Delta C$ denotes the cumulative current value for a period of time from the time point $t_1$ to the time point t2, $Q_{est}$ denotes an estimate of maximum capacity at the time point t2, and $SOH_{new}$ denotes an estimate of SOH at the time point t2. $Q_{ref}$ is a preset value indicating the maximum capacity when the SOH of the battery 20 is 1. $Q_{ref}$ may be referred to as 'design capacity', and may be pre-stored in the memory unit 130.

In relation to Equation 1, when $\Delta SOC$ is too small, $Q_{est}$ may be greatly different from the actual one. Accordingly, the control unit 120 may be configured to determine the SOH or the maximum capacity of the battery 20 using Equation 1 only when $\Delta SOC$ is equal to or larger than a predetermined value (e.g., 0.5).

In determining the maximum capacity (or SOH), to exclude the influence of the above-described nonlinear characteristic, only when both of $SOC_1$ and $SOC_2$ do not fall in the reference range as described below, the control unit 120 may be configured to determine the maximum capacity of the battery 20 using Equation 1.

Hereinafter, the operation for estimating the SOC of the battery 20, performed by the control unit 120, will be described in more detail.

The control unit 120 may calculate an estimate of SOC of the battery 20 in the current cycle using the ampere counting (see Equation 2) based on the current value of the battery information.

<Equation 2>

$$SOC[k + 1] = SOC_e[k] + \frac{i[k + 1]\Delta t}{Q_{est}}$$

Below is the description of the symbols used in Equation 2. $\Delta t$ denotes the time length per cycle. K is a time index that increases by 1 each time $\Delta t$ passes away, and indicates the number of cycles from the time point at which a predetermined event occurred to the current time point. The event may be, for example, the start of charging and discharging of the battery 20 of which voltage is stabilized. The battery 20 of which voltage is stabilized may be the battery 20 on no-load condition in which the current does not flow through the battery 20 and the voltage of the battery 20 is uniformly maintained. In this case, $SOC_e[0]$ may be determined from a data table defining a correspondence relationship between OCV and SOC of the battery 20 (see the OCV-SOC curve shown in FIG. 3) using the OCV of the battery 20 at the time point when the event occurred as an index. The data table is stored in the memory unit 130.

In Equation 2, i[k+1] denotes the current detected in the current cycle, and $SOC_e[k]$ denotes the SOC determined in the previous cycle by the extended Kalman filter. SOC[k+1] is a value indicating the SOC in the current cycle calculated using the ampere counting. In Equation 2, i[k+1] may be replaced with i[k].

Hereinafter, the extended Kalman filter will be described. The extended Kalman filter is an algorithm for periodically updating the SOC of the battery 20, by additionally using the equivalent circuit model 200 of the battery 20 together with the ampere counting represented by Equation 2.

Referring to FIG. 2, the equivalent circuit model 200 includes an OCV source 210, an ohm resistor $R_1$ and a resistor-capacitor (RC) pair 220.

The OCV source 210 simulates the OCV that is the voltage between the positive and negative electrodes of the battery 20 electrochemically stabilized for a long term. The OCV outputted by the OCV source 210 is in a nonlinear functional relationship with the SOC of the battery 20. That is, OCV = $f_1(SOC)$, SOC = $f_2(OCV)$, and $f_1$ and $f_2$ are inverse functions of each other. For example, referring to FIG. 3, 3.3 V = $f_1(0.5)$, and 0.7 = $f_2(3.4$ V).

The OCV outputted by the OCV source 210 may be preset by SOC and temperature through experimentation.

The ohm resistor $R_1$ is associated with IR drop $V_1$ of the battery 20. The IR drop refers to an instantaneous change in voltage across the battery 20 when the battery 20 is switched from the no-load condition to the charging/discharging condition or from the charging/discharging condition to the no-load condition. In an example, the voltage of the battery 20 measured at the time point when the battery 20 on no-load condition starts charging is higher than the OCV. In another example, the voltage of the battery 20 measured at the time point when the battery 20 on no-load condition starts discharging is lower than the OCV. The resistance value of the ohm resistor $R_1$ may be also preset by SOC and temperature through experimentation.

The RC pair 220 outputs overpotential (also known as 'polarization voltage') $V_2$ occurred by an electric double layer of the battery 20, etc., and includes a resistor $R_2$ and a capacitor $C_2$ connected in parallel. The overpotential $V_2$ may be referred to as 'polarization voltage'. The time constant of the RC pair 220 is the multiplication of the resistance value of the resistor $R_2$ by the capacitance of the capacitor C2, and may be preset by SOC and temperature through experimentation.

$V_{ecm}$ is an output voltage of the equivalent circuit model 200, and equals the sum of the OCV from the OCV source 210, the IR drop $V_1$ across the ohm resistor $R_1$ and the overpotential $V_2$ across the RC pair 220.

In the equivalent circuit model 200, the overpotential in the current cycle may be defined as the following Equation 3.

<Equation 3>

$$V_2[k+1] = V_2[k]e^{-\frac{\Delta t}{\tau[k+1]}} + R_2[k+1]i[k+1]\left(1 - e^{-\frac{\Delta t}{\tau[k+1]}}\right)$$

In Equation 3, $R_2[k+1]$ denotes the resistance value of the resistor $R_2$ in the current cycle, $\tau[k+1]$ denotes the time constant of the RC pair 220 in the current cycle, V2[k] denotes the overpotential in the previous cycle, and $V_2[k+1]$ denotes the overpotential in the current cycle. In Equation 3, i[k+1] may be replaced with i[k]. The overpotential V2[0] at the time point when the event occurred may be 0 V(volt).

The following Equation 4 is a first state equation associated with the time update process of the extended Kalman filter, and is derived from a combination of Equation 2 and Equation 3.

<Equation 4>

$$\hat{x}_{k+1}^- = \begin{pmatrix} SOC[k+1] \\ V_2[k+1] \end{pmatrix} = A\hat{x}_k + Bi[k+1]$$

$$\hat{x}_k = \begin{pmatrix} SOC_e[k] \\ V_2[k] \end{pmatrix}$$

$$A = \begin{pmatrix} 1 & 0 \\ 0 & e^{-\frac{\Delta t}{\tau[k+1]}} \end{pmatrix}$$

$$B = \begin{pmatrix} \dfrac{\Delta t}{Q_{est}} \\ R_2[k+1]\left(1 - e^{-\frac{\Delta t}{\tau[k+1]}}\right) \end{pmatrix}$$

In Equation 4 and the following Equations 5 to 8, the superscripted symbol ^ indicates a value estimated by time updates. Additionally, the superscripted symbol⁻indicates a value before correction by measurement updates described below. SOC[k+1] of Equation 4 is an estimate temporarily indicating the SOC in the current cycle, and may be referred to as 'temporary estimate'. $SOC_e[k]$ of Equation 4 is a definitive estimate indicating the SOC in the previous cycle, and may be referred to as 'previous estimate'.

The following Equation 5 is a second state equation associated with the time update process of the extended Kalman filter.

<Equation 5>

$$P_{k+1}^- = A P_k A^T + Q_k$$

$$Q_k = \begin{pmatrix} W1_k & 0 \\ 0 & W2_k \end{pmatrix}$$

In Equation 5, Pk denotes an error covariance matrix corrected in the previous cycle, $Q_k$ denotes a process noise covariance matrix in the previous cycle, T denotes a transpose operator, and $P_{k+1}^-$ denotes an error covariance matrix in the current cycle. In k=0, $P_0$=[ 1 0 ; 0 1 ]. $W1_k$ is first process noise, and is associated with reliability of the ampere counting. $W1_k$, is a predetermined positive number indicating inaccuracy of the cumulative current value calculated using the ampere counting. W2k is second process noise, and is associated with reliability of the equivalent circuit model 200. W2k is a predetermined positive number indicating inaccuracy of the parameters associated with the equivalent circuit model 200.

The control unit 120 may determine OCV information based on the temporary estimate SOC[k+1]. The OCV information includes at least one of a first OCV factor value and a second OCV factor value. The first OCV factor value and the second OCV factor value will be each described in more detail below.

When the time update process using Equation 4 and Equation 5 is completed, the control unit 120 performs a measurement update process.

The following Equation 6 is a first observation equation associated with the measurement update process of the extended Kalman filter.

<Equation 6>

$$K_{k+1} = P_{k+1}^- H_{k+1}^T (H_{k+1} P_{k+1}^- H_{k+1}^T + R)^{-1}$$

$$H_{k+1}^T = \begin{pmatrix} \dfrac{f_1(SOC[k+1]+0.01u) - f_1(SOC[k+1]-0.01u)}{2n} \\ 1 \end{pmatrix}$$

In Equation 6, $K_{k+1}$ denotes a Kalman gain in the current cycle. R is a measurement noise covariance matrix, and has preset components.

In Equation 6, $H_{k+1}$ is a system matrix. The component in the first row and the first column of $H_{k+1}$ indicates change trend in OCV of the battery 20 according to the data table defining the OCV-SOC curve shown in FIG. 3 in estimating the SOC of the battery 20 in the current cycle. n of $H_{k+1}$ is a preset positive integer (e.g., 1).

The change trend in OCV may indicate an OCV range of interest corresponding to a SOC range of interest having the temporary estimate SOC[k+1] as the middle value. An OCV corresponding to the minimum value of the SOC range of interest may be equal to the minimum value of the OCV range of interest. An OCV corresponding to the maximum value of the SOC range of interest may be equal to the maximum value of the OCV range of interest.

u denotes the first OCV factor value, and is a positive number for adjusting the SOC range of interest required to set the change trend in OCV. Accordingly, the OCV range of interest corresponding to the SOC range of interest is adjusted by adjusting u.

The SOC range of interest is a difference between SOC[k+1]+0.01u and SOC[k+1]-0.01u, i.e., 0.02u. The OCV range of interest is a difference between $f_1$(SOC[k+1]+0.01u) and $f_1$(SOC[k+1]-0.01u). For example, when SOC[k+1] is fixed, as u decreases, the minimum value $f_1$(SOC[k+1]-0.01u) of the OCV range of interest increases, and the maximum value $f_1$(SOC[k+1]+0.01u) of the OCV range decreases. Of course, when SOC[k+1] is fixed, as u increases, the minimum value of the OCV range of interest decreases and the maximum value of the OCV range of interest increases.

The control unit 120 may adjust the first OCV factor value u based on the results of comparison between the temporary estimate SOC[k+1] and the reference range. The reference range (see FIG. 3) is a SOC range in which the nonlinear characteristic is above a predetermined level, and may be set through experimentation.

The minimum value of the reference range may be 0% indicating fully discharged state. The maximum value ($SOC_R$ in FIG. 3) of the reference range indicates the boundary between an area in which the nonlinear characteristic is exhibited and the remaining area.

The control unit 120 may determine the maximum value $SOC_R$ of the reference range based on the maximum capacity $Q_{est}$ of the battery. In detail, as a difference between the design capacity $Q_{ref}$ and the maximum capacity $Q_{est}$ increases (i.e., as the battery 20 degrades), the control unit 120 may increase the maximum value $SOC_R$ of the reference range. It is because as the battery 20 degrades, the internal electrochemical state of the battery 20 becomes unstable and the area in which the nonlinear characteristic is exhibited may expand. For example, when a difference between the design capacity $Q_{ref}$ and the maximum capacity $Q_{est}$ is less than a predetermined reference difference value, the predetermined reference value (e.g., 5%) may be determined as the maximum value $SOC_R$ of the reference range. The reference value may indicate the SOC at the boundary between the area in which the nonlinear characteristic of the battery 20 is exhibited and the remaining area when the battery 20 is at Beginning Of Life. When the difference between the design capacity $Q_{ref}$ and the maximum capacity $Q_{est}$ is equal to or larger than the reference difference value, the sum of (i) the difference between the design capacity $Q_{ref}$ and the maximum capacity $Q_{est}$ multiplied by a predetermined scaling coefficient and (ii) the reference value may be determined as the maximum value $SOC_R$ of the reference range. Of course, the maximum value $SOC_R$ of the reference range may be fixed to be equal to the reference value irrespective of the maximum capacity $Q_{est}$.

When the temporary estimate SOC[k+1] is outside of the reference range, the control unit 120 may determine the first OCV factor value u to be equal to a predetermined first slope control value. On the contrary, when the temporary estimate SOC[k+1] is within the reference range, the control unit 120 may determine the first OCV factor value u to be equal to a predetermined second slope control value. The second slope control value may be smaller than the first slope control value. For example, the first slope control value may be 1 that is equal to n, and the second slope control value may be 0.5 that is smaller than n. The first slope control value and the second slope control value may be preset based on experimental results.

The OCV range of interest when the first OCV factor value u is equal to the second slope control value is narrower than the OCV range of interest when the first OCV factor value u is equal to the first slope control value. Accordingly, when the temporary estimate SOC[k+1] is within the reference range, changes in OCV of the battery 20 strongly showing the nonlinear characteristic may be precisely reflected on $H_{k+1}$. Of course, the first OCV factor value u may be a constant (e.g., equal to n) irrespective of the temporary estimate SOC[k+1].

The following Equation 7 is a second observation equation associated with the measurement update process of the extended Kalman filter. SOC[k+1] and $V_2$[k+1] obtained from Equation 4 are each corrected by Equation 7.

<Equation 7>

$$\hat{x}_{k+1} = \begin{pmatrix} SOC_e[k+1] \\ V_{2e}[k+1] \end{pmatrix}$$

$$= \hat{x}_{k+1}^- + K_{k+1}\{z_{k+1} - (f_1(SOC[k+1]) + V_1[k+1] + V_2[k+1])\}$$

In Equation 7, $z_{k+1}$ denotes the voltage of the battery 20 measured in the current cycle, $V_1$[k+1] denotes the voltage across the ohm resistor $R_1$ in the current cycle, and may equal the multiplication of any one of i[k+1] and i[k] by $R_1$[k+1]. $R_1$[k+1] is the resistance value of the ohm resistor $R_1$ in the current cycle. The control unit 120 may determine $R_1$[k+1] based on the temperature value of the battery information. To this end, the memory unit 130 records a first lookup table defining a correspondence relationship between the temperature value and the resistance value of the ohm resistor $R_1$. The control unit 120 may obtain the resistance value mapped to the temperature value in the current cycle as $R_1$[k+1] from the first lookup table using the temperature value in the current cycle as an index.

In Equation 7, $f_1$(SOC[k+1]) denotes the second OCV factor value. When the temporary estimate SOC[k+1] is outside of the reference range, the control unit 120 may determine the OCV corresponding to the temporary estimate SOC[k+1] as the second OCV factor value from the data table (see FIG. 3). In this case, $f_1$(SOC[k+1]) indicates an estimate of OCV in the current cycle. On the contrary, when the temporary estimate SOC[k+1] is within the reference range, the control unit 120 may determine the OCV ($V_R$ in FIG. 2) corresponding to the maximum value $SOC_R$ of the reference range as the second OCV factor value from the data table (see FIG. 3).

Additionally, the control unit 120 sets i[k+1](or i[k]) of Equation 4 to be equal to the current value and $z_{k+1}$ of Equation 7 to be equal to the voltage value of the battery information. Accordingly, the control unit 120 may obtain $SOC_e[k+1]$ by correcting the temporary estimate SOC[k+1] using Equation 7. $SOC_e[k+1]$ is a value determined as an estimate for SOC of the battery 20 in the current cycle, and may be referred to as 'definitive estimate'. For reference, $V_{2e}[k+1]$ is the result of correcting $V_2[k+1]$ of Equation 4 by Equation 7. $SOC_e[k+1]$ is used for $SOC_e[k]$ of Equation 4 in the next cycle.

The following Equation 8 is a third observation equation associated with the measurement update process of the extended Kalman filter.

<Equation 8>

$$P_{k+1} = (E - K_{k+1}H_{k+1})P_{k+1}^-$$

In Equation 8, E denotes the unit matrix. $P_{k+1}^-$ obtained from Equation 5 is corrected to Pk+i by Equation 8.

The control unit 120 updates the definitive estimate indicating the SOC of the battery 20 in each cycle by performing each calculation step of Equations 4 to 8 at least once each time the time index k increases by 1.

The control unit 120 determines $R_2[k+1]$ and $\tau[k+1]$ of Equation 4 based on the temperature value and the SOC determined in the previous cycle. The memory unit 130 may record a second lookup table defining a correspondence relationship between the SOC, the temperature value and the resistance value of the resistor $R_2$. The control unit 120 may obtain the resistance value mapped to the temperature value and the SOC determined in the previous cycle as $R_2[k+1]$ of Equation 4 from the second lookup table using the temperature value and the SOC determined in the previous cycle as an index. Additionally, the memory unit 130 may record a third lookup table defining a correspondence relationship between the SOC, the temperature value and the time constant. The control unit 120 may obtain the time constant mapped to the temperature value and the SOC determined in the previous cycle as $\tau[k+1]$ of Equation 4 from the third lookup table using the temperature value and the SOC determined in the previous cycle as an index.

To control the switch 30, the control unit 120 may selectively output the switching signal SS. When the definitive estimate $SOC_e[k+1]$ is within the reference range, the control unit 120 may regulate the duty cycle of the switching signal SS below a predetermined reference duty cycle (e.g., 0.2). When the duty cycle of the switching signal SS is regulated below the reference duty cycle, a rapid change in the voltage, current and temperature of the battery 20 may be suppressed.

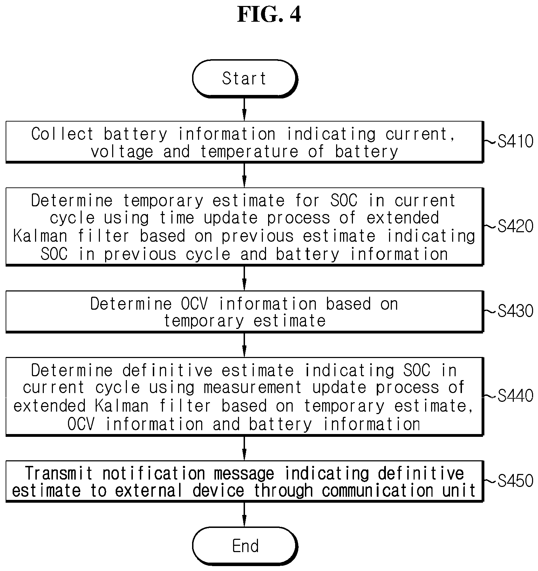

FIG. 4 is an exemplary flowchart showing a battery management method that may be performed by the battery management system of FIG. 1. The method of FIG. 4 may be periodically performed from the time point at which the event occurred. The method of FIG. 4 may end when charging/discharging the battery 20 is stopped.

Referring to FIGS. 1 to 4, in step S410, the control unit 120 collects battery information indicating the current, voltage and temperature of the battery 20 from the sensing unit 110.

In step S420, the control unit 120 determines a temporary estimate SOC[k+1] for the SOC in the current cycle using the time update process of the extended Kalman filter based on the previous estimate $SOC_e[k]$ indicating the SOC in the previous cycle and the battery information (see Equations 4 and 5).

In step S430, the control unit 120 determines OCV information based on the temporary estimate SOC[k+1].

In step S440, the control unit 120 determines a definitive estimate $SOC_e[k+1]$ indicating the SOC in the current cycle using the measurement update process of the extended Kalman filter based on the temporary estimate SOC[k+1], the OCV information and the battery information (see Equations 6 to 8).

In step S450, the control unit 120 transmits a notification message indicating the definitive estimate $SOC_e[k+1]$ to the external device 2 through the communication unit 140.

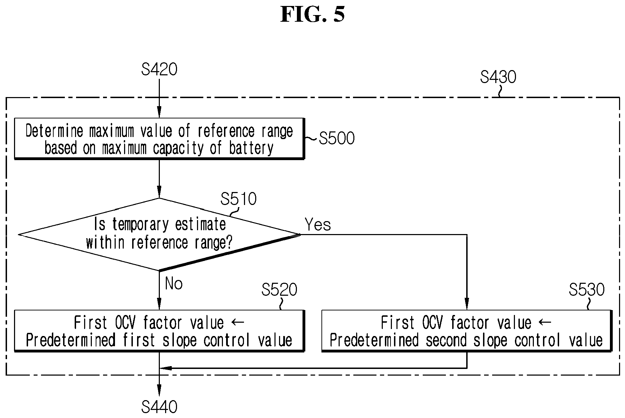

FIG. 5 is an exemplary flowchart showing a method of determining the first OCV factor value as the OCV information according to an embodiment of the present disclosure. The method of FIG. 5 corresponds sub-steps of the step S430 of FIG. 4.

Referring to FIGS. 1 to 5, in step S500, the control unit 120 determines the maximum value $SOC_R$ of the reference range based on the maximum capacity $Q_{est}$ of the battery 20. The minimum value of the reference range may be 0%. The step S500 is not essential, and may be omitted from the method of FIG. 5.

In step S510, the control unit 120 determines whether the temporary estimate SOC[k+1] is within the reference range. That is, the control unit 120 determines whether the temporary estimate SOC[k+1] is equal to or less than the maximum value $SOC_R$ of the reference range. When a value of the step S510 is "NO", step S520 is performed. When the value of the step S510 is "YES", step S530 is performed.

In step S520, the control unit 120 determines the first OCV factor value (u in Equation 6) to be equal to the predetermined first slope control value.

In step S530, the control unit 120 determines the first OCV factor value to be equal to the predetermined second slope control value. The second slope control value is smaller than the first slope control value.

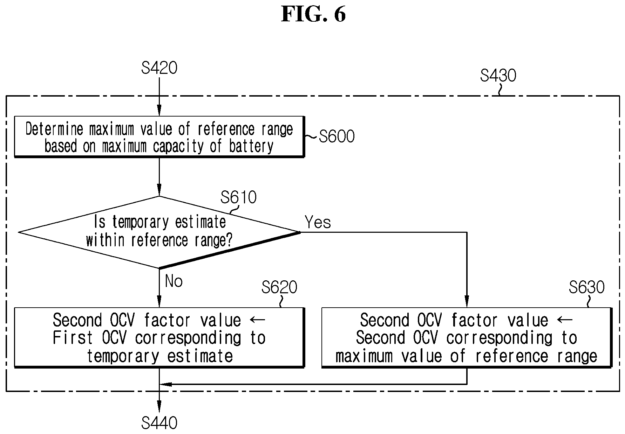

FIG. 6 is an exemplary flowchart showing a method of determining the second OCV factor value as the OCV information according to another embodiment of the present disclosure. The method of FIG. 6 corresponds to sub-steps of the step S430 of FIG 4.

Referring to FIGS. 1 to 4 and 6, in step S600, the control unit 120 determines the maximum value $SOC_R$ of the reference range based on the maximum capacity $Q_{est}$ of the battery 20. The minimum value of the reference range may be 0%. The step S600 is not essential, and may be omitted from the method of FIG. 6.

In step S610, the control unit 120 determines whether the temporary estimate SOC[k+1] is within the reference range. That is, the control unit 120 determines whether the temporary estimate SOC[k+1] is equal to or less than the maximum value $SOC_R$ of the reference range. When a value of the step S610 is "NO", step S620 is performed. When the value of the step S610 is "YES", step S630 is performed.

In step S620, the control unit 120 determines the second OCV factor value ($f_1$(SOC[k+1]) in Equation 7) to be equal to a first OCV corresponding to the temporary estimate SOC[k+1]. For example, referring to FIG. 3, when SOC[k+1] = 0.5 > $SOC_R$, First OCV= 3.3 [V] = Second OCV factor value.

In step S630, the control unit 120 determines the second OCV factor value to be equal to a second OCV $V_R$ corresponding to the maximum value $SOC_R$ of the reference range. For example, referring to FIG. 3, when SOC[k+1] ≤ $SOC_R$, Second OCV = $V_R$ [V] = Second OCV factor value.

Meanwhile, only one of the method of FIG. 5 and the method of FIG. 6 is not performed, and the two methods may be all performed. When both the method of FIG. 5 and the method of FIG. 6 are performed, only one of the step S500 and the step S600 may be performed.

The embodiments of the present disclosure described hereinabove are not implemented only through the apparatus and method, and may be implemented through programs that perform functions corresponding to the configurations of the embodiments of the present disclosure or recording media having the programs recorded thereon, and such implementation may be easily achieved by those skilled in the art from the disclosure of the embodiments previously described.

While the present disclosure has been hereinabove described with regard to a limited number of embodiments and drawings, the present disclosure is not limited thereto and it is obvious to those skilled in the art that various modifications and changes may be made thereto without departing from the scope of the invention, as defined by the appended claims.

## Claims

1. A battery management system comprising:

   a sensing unit configured to generate battery information indicating a current, a voltage and a temperature of a battery; and
   a control unit configured to estimate a state of charge, SOC, of the battery using an extended Kalman filter based on the battery information,
   wherein the battery management system is **characterised in that** the control unit is configured to:

   determine a temporary estimate for a SOC in a current cycle using a time update process of the extended Kalman filter based on a previous estimate and the battery information, wherein the previous estimate indicates a SOC in a previous cycle,
   determine open circuit voltage, OCV, information based on the temporary estimate, and
   determine a definitive estimate indicating the SOC in the current cycle using a measurement update process of the extended Kalman filter based on the temporary estimate, the OCV information and the battery information.

2. The battery management system according to claim 1, wherein the OCV information includes a first OCV factor value, and
   the control unit is configured to determine the first OCV factor value to be equal to a predetermined first slope control value when the temporary estimate is outside of a reference range.

3. The battery management system according to claim 2, wherein the control unit is configured to determine the first OCV factor value to be equal to a second slope control value when the temporary estimate is within the reference range, the second slope control value being smaller than the first slope control value.

4. The battery management system according to claim 3, wherein the control unit is configured to determine a maximum value of the reference range based on a maximum capacity of the battery.

5. The battery management system according to claim 4, wherein the control unit is configured to increase the maximum value of the reference range as a difference between a design capacity of the battery and the maximum capacity increases.

6. The battery management system according to claim 1, wherein the OCV information includes a second OCV factor value, and
the control unit is configured to determine the second OCV factor value to be equal to a first OCV corresponding to the temporary estimate from a data table defining a correspondence relationship between the SOC and the OCV of the battery when the temporary estimate is outside of the reference range.

7. The battery management system according to claim 6, wherein the control unit is configured to determine the second OCV factor value to be equal to a second OCV corresponding to a maximum value of the reference range when the temporary estimate is within the reference range, and
wherein the maximum value of the reference range is equal to or larger than a predetermined reference value.

8. A battery pack comprising the battery management system according to any one of claims 1 to 7.

9. An electric vehicle comprising the battery pack according to claim 8.

10. A battery management method executable by the battery management system according to any one of claims 1 to 7, the battery management method comprising:

collecting battery information indicating a current, a voltage and a temperature of the battery; wherein the battery management method is **characterised by** determining a temporary estimate for a state of charge, SOC, in a current cycle using a time update process of an extended Kalman filter based on a previous estimate indicating a SOC in a previous cycle and the battery information;
determining open circuit voltage, OCV, information based on the temporary estimate; and
determining a definitive estimate indicating the SOC in the current cycle using a measurement update process of the extended Kalman filter based on the temporary estimate, the OCV information and the battery information.

11. The battery management method according to claim 10, wherein determining the OCV information comprises:

determining a first OCV factor value to be equal to a predetermined first slope control value when the temporary estimate is outside of a reference range; and
determining the first OCV factor value to be equal to a second slope control value when the temporary estimate is within the reference range, the second slope control value being smaller than the first slope control value, and
wherein the OCV information includes the first OCV factor value.

12. The battery management method according to claim 10, wherein determining the OCV information comprises:

determining a second OCV factor value to be equal to an OCV corresponding to the temporary estimate from a data table defining a correspondence relationship between the SOC and the OCV of the battery when the temporary estimate is outside of a reference range; and
determining the second OCV factor value to be equal to a threshold voltage associated with the reference range when the temporary estimate is within the reference range, and
wherein the OCV information includes the second OCV factor value.

**Patentansprüche**

1. Batterie-Verwaltungssystem, umfassend:

eine Erfassungseinheit, welche dazu eingerichtet ist, Batterieinformationen zu erzeugen, welche einen Strom, eine Spannung und eine Temperatur einer Batterie anzeigen; und

eine Steuereinheit, welche dazu eingerichtet ist, einen Ladungszustand, SOC, der Batterie unter Verwendung eines erweiterten Kalman-Filters auf Grundlage der Batterieinformationen zu schätzen,

wobei das Batterie-Verwaltungssystem **dadurch gekennzeichnet ist, dass** die Steuereinheit dazu eingerichtet ist:

eine temporäre Schätzung für einen SOC in einem momentanen Zyklus unter Verwendung eines Zeit-Aktualisierungsprozesses des erweiterten Kalman-Filters auf Grundlage einer vorhergehenden Schätzung und der Batterieinformationen zu bestimmen, wobei die vorhergehende Schätzung einen SOC in einem vorhergehenden Zyklus anzeigt,

Leerlaufspannung-, OCV-, Informationen auf Grundlage der temporären Schätzung zu bestimmen, und

eine definitive Schätzung, welche den SOC in dem momentanen Zyklus anzeigt, unter Verwendung eines Messung-Aktualisierungsprozesses des erweiterten Kalman-Filters auf Grundlage der temporären Schätzung, der OCV-Informationen und der Batterieinformationen zu bestimmen.

2. Batterie-Verwaltungssystem nach Anspruch 1, wobei die OCV-Informationen einen ersten OCV-Faktorwert umfassen, und

die Steuereinheit dazu eingerichtet ist, den ersten OCV-Faktorwert derart zu bestimmen, dass er gleich einem vorbestimmten ersten Steigung-Steuerwert ist, wenn die temporäre Schätzung außerhalb eines Referenzbereichs liegt.

3. Batterie-Verwaltungssystem nach Anspruch 2, wobei die Steuereinheit dazu eingerichtet ist, den ersten OCV-Faktorwert derart zu bestimmen, dass er gleich einem zweiten Steigung-Steuerwert ist, wenn die temporäre Schätzung innerhalb des Referenzbereichs liegt, wobei der zweite Steigung-Steuerwert kleiner als der erste Steigung-Steuerwert ist.

4. Batterie-Verwaltungssystem nach Anspruch 3, wobei die Steuereinheit dazu eingerichtet ist, einen maximalen Wert des Referenzbereichs auf Grundlage einer maximalen Kapazität der Batterie zu bestimmen.

5. Batterie-Verwaltungssystem nach Anspruch 4, wobei die Steuereinheit dazu eingerichtet ist, den maximalen Wert des Referenzbereichs zu erhöhen, wenn sich eine Differenz zwischen einer Auslegungskapazität der Batterie und der maximalen Kapazität erhöht.

6. Batterie-Verwaltungssystem nach Anspruch 1, wobei die OCV-Informationen einen zweiten OCV-Faktorwert umfassen, und

die Steuereinheit dazu eingerichtet ist, den zweiten OCV-Faktorwert derart zu bestimmen, dass er gleich einem ersten OCV ist, entsprechend der temporären Schätzung von einer Datentabelle, welche eine Korrespondenzbeziehung zwischen dem SOC und der OCV der Batterie definiert, wenn die temporäre Schätzung außerhalb des Referenzbereichs liegt.

7. Batterie-Verwaltungssystem nach Anspruch 6, wobei die Steuereinheit dazu eingerichtet ist, den zweiten OCV-Faktorwert derart zu bestimmen, dass er gleich einem zweiten OCV ist, welcher einem maximalen Wert des Referenzbereichs entspricht, wenn die temporäre Schätzung innerhalb des Referenzbereichs liegt, und

wobei der maximale Wert des Referenzbereichs gleich oder größer als ein vorbestimmter Referenzwert ist.

8. Batteriepack, umfassend das Batterie-Verwaltungssystem nach einem der Ansprüche 1 bis 7.

9. Elektrofahrzeug, umfassend den Batteriepack nach Anspruch 8.

10. Batterie-Verwaltungsverfahren, welches durch das Batterie-Verwaltungssystem nach einem der Ansprüche 1 bis 7 durchführbar ist, wobei das Batterie-Verwaltungsverfahren umfasst:

Sammeln von Batterieinformationen, welche einen Strom, eine Spannung und eine Temperatur der Batterie anzeigen; wobei das Batterie-Verwaltungsverfahren **gekennzeichnet ist durch**:

Bestimmen einer temporären Schätzung für einen Ladungszustand, SOC, in einem momentanen Zyklus unter Verwendung eines Zeit-Aktualisierungsprozesses eines erweiterten Kalman-Filters auf Grundlage einer vorhergehenden Schätzung, welche einen SOC in einem vorhergehenden Zyklus anzeigt, und der Batterieinformationen;

Bestimmen von Leerlaufspannung-, OCV-, Informationen auf Grundlage der temporären Schätzung; und Bestimmen einer definitiven Schätzung, welche den SOC in dem momentanen Zyklus anzeigt, unter Verwendung eines Messung-Aktualisierungsprozesses des erweiterten Kalman-Filters auf Grundlage der temporären Schätzung, der OCV-Informationen und der Batterieinformationen.

**11.** Batterie-Verwaltungsverfahren nach Anspruch 10, wobei das Bestimmen der OCV-Informationen umfasst:

Bestimmen eines ersten OCV-Faktorwerts derart, dass er gleich einem vorbestimmten ersten Steigung-Steuerwert wird, wenn die temporäre Schätzung außerhalb eines Referenzbereichs liegt; und Bestimmen des ersten OCV-Faktorwerts derart, dass er gleich einem zweiten Steigung-Steuerwert wird, wenn die temporäre Schätzung innerhalb des Referenzbereichs liegt, wobei der zweite Steigung-Steuerwert kleiner als der erste Steigung-Steuerwert ist, und wobei die OCV-Informationen den ersten OCV-Faktorwert umfassen.

**12.** Batterie-Verwaltungsverfahren nach Anspruch 10, wobei das Bestimmen der OCV-Informationen umfasst:

Bestimmen eines zweiten OCV-Faktorwerts derart, dass er gleich einer OCV wird, entsprechend der temporären Schätzung von einer Datentabelle, welche eine Korrespondenzbeziehung zwischen dem SOC und der OCV der Batterie definiert, wenn die temporäre Schätzung außerhalb eines Referenzbereichs liegt; und Bestimmen des zweiten OCV-Faktorwerts derart, dass er gleich einer Schwellenwert-Spannung wird, welche dem Referenzbereich zugeordnet ist, wenn die temporäre Schätzung innerhalb des Referenzbereichs liegt, und wobei die OCV-Informationen den zweiten OCV-Faktorwert umfassen.

## Revendications

**1.** Système de gestion de batterie comprenant :

une unité de détection configurée pour générer des informations de batterie indiquant une intensité, une tension et une température d'une batterie ; et une unité de commande configurée pour estimer un état de charge, SOC, de la batterie en utilisant un filtre de Kalman étendu sur la base des informations de batterie, dans lequel le système de gestion de batterie est **caractérisé en ce que** l'unité de commande est configurée pour :

déterminer une estimation provisoire d'un SOC dans un cycle courant en utilisant un processus de mise à jour temporelle du filtre de Kalman étendu sur la base d'une estimation précédente et des informations de batterie, dans lequel l'estimation précédente indique un SOC dans un cycle précédent, déterminer des informations de tension en circuit ouvert, OCV, sur la base de l'estimation provisoire, et déterminer une estimation définitive indiquant le SOC dans le cycle courant en utilisant un processus de mise à jour de mesure du filtre de Kalman étendu sur la base de l'estimation provisoire, des informations OCV et des informations de batterie.

**2.** Système de gestion de batterie selon la revendication 1, dans lequel les informations OCV incluent une première valeur de facteur OCV, et l'unité de commande est configurée pour déterminer que la première valeur de facteur OCV est égale à une première valeur de commande de pente prédéterminée lorsque l'estimation provisoire est à l'extérieur d'une plage de référence.

**3.** Système de gestion de batterie selon la revendication 2, dans lequel l'unité de commande est configurée pour déterminer que la première valeur de facteur OCV est égale à une seconde valeur de commande de pente lorsque l'estimation provisoire est à l'intérieur de la plage de référence, la seconde valeur de commande de pente étant inférieure à la première valeur de commande de pente.

**4.** Système de gestion de batterie selon la revendication 3, dans lequel l'unité de commande est configurée pour déterminer une valeur maximale de la plage de référence sur la base d'une capacité maximale de la batterie.

**5.** Système de gestion de batterie selon la revendication 4, dans lequel l'unité de commande est configurée pour augmenter la valeur maximale de la plage de référence au fur et à mesure de l'augmentation d'une différence entre une capacité nominale de la batterie et la capacité maximale.

6. Système de gestion de batterie selon la revendication 1, dans lequel les informations OCV incluent une seconde valeur de facteur OCV, et

l'unité de commande est configurée pour déterminer que la seconde valeur de facteur OCV est égale à une première OCV correspondant à l'estimation provisoire à partir d'une table de données définissant une relation de correspondance entre le SOC et l'OCV de la batterie lorsque l'estimation provisoire est à l'extérieur de la plage de référence.

7. Système de gestion de batterie selon la revendication 6, dans lequel l'unité de commande est configurée pour déterminer que la seconde valeur de facteur OCV est égale à une seconde OCV correspondant à une valeur maximale de la plage de référence lorsque l'estimation provisoire est à l'intérieur de la plage de référence, et dans lequel la valeur maximale de la plage de référence est supérieure ou égale à une valeur de référence prédéterminée.

8. Bloc-batterie comprenant le système de gestion de batterie selon l'une quelconque des revendications 1 à 7.

9. Véhicule électrique comprenant le bloc-batterie selon la revendication 8.

10. Procédé de gestion de batterie exécutable par le système de gestion de batterie selon l'une quelconque des revendications 1 à 7, le procédé de gestion de batterie comprenant :

la collecte d'informations de batterie indiquant une intensité, une tension et une température de la batterie ; dans lequel le procédé de gestion de batterie est **caractérisé par** :

la détermination d'une estimation provisoire d'un état de charge, SOC, dans un cycle courant en utilisant un processus de mise à jour temporelle d'un filtre de Kalman étendu sur la base d'une estimation précédente indiquant un SOC dans un cycle précédent et des informations de batterie ;
la détermination d'informations de tension en circuit ouvert, OCV, sur la base de l'estimation provisoire ; et
la détermination d'une estimation définitive indiquant le SOC dans le cycle courant en utilisant un processus de mise à jour de mesure du filtre de Kalman étendu sur la base de l'estimation provisoire, des informations OCV et des informations de batterie.

11. Procédé de gestion de batterie selon la revendication 10, dans lequel la détermination des informations OCV comprend :

la détermination que la première valeur de facteur OCV est égale à une première valeur de commande de pente prédéterminée lorsque l'estimation provisoire est à l'extérieur d'une plage de référence ; et
la détermination que la première valeur de facteur OCV est égale à une seconde valeur de commande de pente lorsque l'estimation provisoire est à l'intérieur de la plage de référence, la seconde valeur de commande de pente étant inférieure à la première valeur de commande de pente, et
dans lequel les informations OCV incluent la première valeur de facteur OCV.

12. Procédé de gestion de batterie selon la revendication 10, dans lequel la détermination des informations OCV comprend :

la détermination qu'une seconde valeur de facteur OCV est égale à une OCV correspondant à l'estimation provisoire à partir d'une table de données définissant une relation de correspondance entre le SOC et l'OCV de la batterie lorsque l'estimation provisoire est à l'extérieur d'une plage de référence ; et
la détermination que la seconde valeur de facteur OCV est égale à une tension de seuil associée à la plage de référence lorsque l'estimation provisoire est à l'intérieur de la plage de référence, et
dans lequel les informations OCV incluent la seconde valeur de facteur OCV.

# FIG. 1

**FIG. 2**

**FIG. 3**

## FIG. 4

```
              ┌──────────┐
              │  Start   │
              └────┬─────┘
                   │
┌──────────────────────────────────────────────┐
│  Collect battery information indicating       │ ~S410
│     current, voltage and temperature of       │
│                battery                        │
└───────────────────┬──────────────────────────┘
                    │
┌──────────────────────────────────────────────┐
│  Determine temporary estimate for SOC in      │
│    current cycle using time update process    │ ~S420
│  of extended Kalman filter based on previous  │
│  estimate indicating SOC in previous cycle    │
│           and battery information             │
└───────────────────┬──────────────────────────┘
                    │
┌──────────────────────────────────────────────┐
│      Determine OCV information based on        │ ~S430
│             temporary estimate                │
└───────────────────┬──────────────────────────┘
                    │
┌──────────────────────────────────────────────┐
│  Determine definitive estimate indicating     │
│   SOC in current cycle using measurement      │ ~S440
│   update process of extended Kalman filter    │
│  based on temporary estimate, OCV information │
│            and battery information            │
└───────────────────┬──────────────────────────┘
                    │
┌──────────────────────────────────────────────┐
│  Transmit notification message indicating     │ ~S450
│  definitive estimate to external device       │
│       through communication unit              │
└───────────────────┬──────────────────────────┘
                    │
              ┌──────────┐
              │   End    │
              └──────────┘
```

## FIG. 5

## FIG. 6

```
                    S420                                           S430
                     │                                             │
      ┌──────────────┼─────────────────────────────────────────────┐
      │  ┌──────────────────────────────────────┐                    │
      │  │ Determine maximum value of reference  │                    │
      │  │ range based on maximum capacity of    │ ~S600             │
      │  │ battery                               │                    │
      │  └──────────────────────────────────────┘                    │
      │                     │                                         │
      │                     ▼        S610                             │
      │              ╱──────────────────╲          Yes               │
      │            ╱  Is temporary estimate ╲───────────────┐        │
      │            ╲  within reference range? ╱              │        │
      │              ╲──────────────────╱                    │        │
      │                     │ No      S620                    ▼  S630  │
      │  ┌──────────────────────────────┐  ┌───────────────────────┐ │
      │  │ Second OCV factor value ←     │  │ Second OCV factor     │ │
      │  │ First OCV corresponding to    │  │ value ← Second OCV    │ │
      │  │ temporary estimate            │  │ corresponding to      │ │
      │  └──────────────────────────────┘  │ maximum value of      │ │
      │                     │               │ reference range       │ │
      │                     │◄──────────────└───────────────────────┘ │
      └─────────────────────┼────────────────────────────────────────┘
                            ▼
                          S440
```

**EP 3 872 507 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2014214348 A1
- US 2007005276 A1